Europäisches Patentamt

European Patent Office

Office européen des brevets

(19)

(11) **EP 0 929 818 B1**

(12) **EUROPÄISCHE PATENTSCHRIFT**

(45) Veröffentlichungstag und Bekanntmachung des Hinweises auf die Patenterteilung:
**08.05.2002 Patentblatt 2002/19**

(51) Int Cl.⁷: $G01R\ 19/00$, H02P 7/29, H01H 47/32

(21) Anmeldenummer: **97941850.6**

(22) Anmeldetag: **29.08.1997**

(86) Internationale Anmeldenummer:
**PCT/DE97/01888**

(87) Internationale Veröffentlichungsnummer:
**WO 98/14788 (09.04.1998 Gazette 1998/14)**

(54) **ELEKTRISCHE SCHALTUNG ZUR ERMITTLUNG EINES LASTSTROMS**

ELECTRICAL CIRCUIT TO DETECT LOAD CURRENT

CIRCUIT ELECTRIQUE POUR DETERMINER UN COURANT DE CHARGE

(84) Benannte Vertragsstaaten:
**DE ES FR GB IT SE**

(30) Priorität: **30.09.1996 DE 19640190**

(43) Veröffentlichungstag der Anmeldung:
**21.07.1999 Patentblatt 1999/29**

(73) Patentinhaber: **ROBERT BOSCH GMBH**
**70442 Stuttgart (DE)**

(72) Erfinder: **KESSLER, Martin**
**D-77815 Bühl (DE)**

(56) Entgegenhaltungen:
**DE-A- 2 540 156          DE-A- 2 850 883**
**US-A- 4 967 309**

- **HEUMANN ET AL.: "GRUBENLOKOMOTIVEN MIT PULSSTEUERUNGDER GLEICHSTROM-FAHRMOTOREN..." AEG MITTEILUNGEN, Bd. 55, Nr. 2, 1965, BERLIN, Seiten 131-132, XP002051162**
- **PATENT ABSTRACTS OF JAPAN vol. 8, no. 63 (E-233) [1500] , 24.März 1984 & JP 58 212393 A (INOUE JAPAX KENKYUSHO K.K.), 10.Dezember 1983,**

**Beschreibung**

Stand der Technik

Die Erfindung betrifft eine Schaltung zur Ermittlung des Laststroms einer getaktet angesteuerten, zumindest einen induktiven Anteil aufweisenden Last nach der Gattung der unabhängigen Ansprüche.

Aus der DE 28 50 883 A1 ist eine gattungsgemäße elektrische Schaltung bekannt geworden, bei der zur Stromerfassung des durch die Last fließenden Stroms in Serie zur Last ein Shunt geschaltet ist. Der Shunt erfaßt den durch die Last fließenden Strom während der Einschaltzeit sowie während der Ausschaltzeit des getakteten Betriebs, wobei während der Ausschaltzeit ein Freilaufstrom auftritt. In Abhängigkeit vom Laststrom sowohl während des eingeschalteten als auch des ausgeschalteten Betriebszustands wird durch Vergleich mit einer vorgegebenen Referenzspannung mittels eines Komparators das Tastverhältnis des getakteten Betriebs festgelegt. Das Tastverhältnis kann nicht frei gewählt werden, da es sich nach dem Belastungszustand der Last richtet. Vorgegeben ist ein Grenzwert für das Tastverhältnis derart, das ein Überstrom vermieden wird.

Aus einem Fachzeitschriftenbeitrag von Heumann et. al. in "AEG Mitteilungen", Bd. 55, Nr. 2, 1965, Berlin, S. 131-132, ist ein Stromregler für einen Gleichstrommotor bekannt geworden, der in einem getakteten Betrieb von einer Gleichspannungsquelle gespeist wird. Der im Motorstromkreis fließende Strom wird unabhängig vom Betriebszustand während der Einschaltphase und der Abschaltphase des getakteten Betriebs erfaßt und zur Regelung herangezogen. Der Regelung zugrunde gelegt werden der Mittelwert des Stroms, der aus dem erfaßten Motorstrom und dem als bekannt vorausgesetzten Tastverhältnis ermittelt wird.

Der Erfindung liegt die Aufgabe zugrunde, eine elektrische Schaltung zur Ermittlung des Laststroms einer getakteten gesteuerten, zumindest einen induktiven Anteil aufweisenden Last anzugeben, die auf einer Erfassung des Freilaufstroms beruht.

Vorteile der Erfindung

Vorgesehen ist ein Shunt, der gemäß einer ersten Ausführung zur Stromermittlung im Freilaufstromkreis angeordnet ist, so dass er den Freilaufstrom erfaßt. Der Freilaufstrom wird als Maß für die Bestimmung des Laststroms herangezogen. Der Laststrom wird aus der Beziehung

$$I_M = \frac{I_F}{1-D}$$

ermittelt, wobei $I_M$ der Laststrom, $I_F$ der Freilaufstrom und D das Tastverhältnis der getakteten Steuerung ist.

Die Anordnung des Shunts im Freilaufstromkreis bedeutet, dass parallel zur Last die Reihenschaltung eines Freilaufelements, beispielsweise einer Freilaufdiode, und des Shunts liegt, und dass die Versorgungsspannung parallel zur Last liegt, wobei mittels eines geeigneten Schalters, beispielsweise eines Transistors, die Versorgungsspannung getaktet an die Last gelegt wird.

Gemäß einer anderen Ausführung ist vorgesehen, dass der Shunt in Reihe zur Last liegt und dass der Freilaufkreis parallel zu der Reihenschaltung von Last und Shunt angeordnet ist. Der Laststrom IM wird auch gemäß dieser Ausführung nach der bereits angegebenen Beziehung bestimmt. Die Versorgungsspannung liegt parallel zur Reihenschaltung von Last und Shunt.

Vorteilhafte Weiterbildungen und Ausgestaltungen der erfindungsgemäßen Schaltungsanordnungen ergeben sich aus abhängigen Ansprüchen.

Gemäß einer Weiterbildung ist vorgesehen, dass die Last ein Elektromotor, insbesondere ein permanenterregter Gleichstrommotor ist.

Ferner ist es vorteilhaft, wenn der Widerstand des Shunts sehr viel kleiner als der ohmsche Anteil an der Last gewählt ist.

Nach einer vorteilhaften Weiterbildung der Erfindung ist vorgesehen, dass das Tastverhältnis definiert ist durch den Quotienten der Lastspannung, insbesondere Motorspannung, und der Versorgungsspannung.

Die Dimensionierung ist vorzugsweise derart gewählt, dass während der Freilaufzeit der Laststrom, insbesondere Motorstrom, in gleicher oder fast gleicher Höhe weiterfließt.

Eine vorteilhafte Ausgestaltung sieht vor, dass der Motorstrom $I_M$ aus der Beziehung

$$I_M = \frac{U_{RS}/R_s}{1-D},$$

wobei $U_{RS}$ durch die elektrische Spannung am Shunt, $R_S$ der Widerstand des Shunts und D wieder das Tastverhältnis der getakteten Ansteuerung ist.

Vorteilhafte Weiterbildungen und Ausgestaltungen der erfindungsgemäßen elektrischen Schaltungen ergeben sich aus weiteren abhängigen Ansprüchen und aus der folgenden Beschreibung.

Zeichnung

Die Erfindung wird im folgenden anhand der Figuren näher erläutert. Es zeigt:

Figur 1    eine Schaltung zur Ermittlung eines Laststroms,

Figur 2    eine weitere Schaltung zur Ermittlung eines Laststroms,

Figur 3    ein Diagramm der Shunt-Spannungen nach den Schaltungen der Figuren 1 und 2,

Figur 4    ein Diagramm der Verlustleistungen im Shunt nach den Schaltungen der Figuren 1 und 2 und

Figur 5    ein Diagramm der Verlustleistungen im Shunt nach den Schaltungen der Figuren 1 und 2 bei quadratischer Lastkennlinie.

Beschreibung von Ausführungsbeispielen

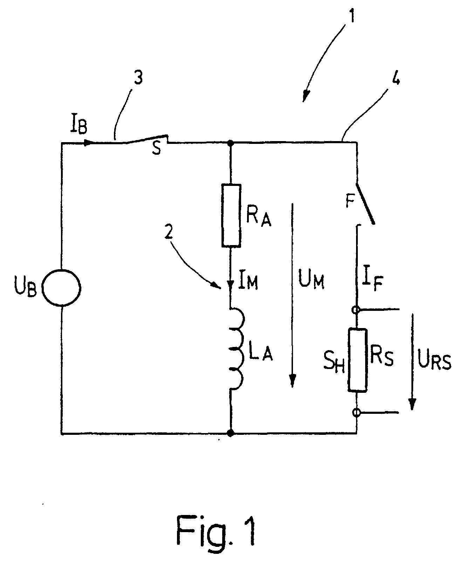

Die Figur 1 zeigt eine Schaltung 1, die eine Versorgungsspannung $U_B$ aufweist, die über ein Schalter S an eine Last 2 angelegt werden kann. Der Schalter S kann beispielsweise durch einen Endstufentransistor realisiert werden. Die Last 2 weist einen ohmschen und einen induktiven Anteil auf. Der ohmsche Anteil ist mit dem Widerstand $R_A$ und der induktive Anteil durch die Spule $L_A$ gekennzeichnet. Die Last kann beispielsweise von einem Elektromotor, insbesondere einem permanent erregten Gleichstrommotor, gebildet sein. In der Zuleitung 3 fließt der Versorgungsstrom $I_B$ (zum Beispiel im Bereich der Zuleitung 3 zwischen dem einen Pol der Versorgungsspannung $U_B$ und dem Schalter S). Über der Last 2, also über der Reihenschaltung von dem Widerstand $R_A$ und der Spule $L_A$, liegt die Lastspannung; im vorliegenden Fall die Motorspannung $U_M$. Parallel zur Last 2 liegt ein Freilaufkreis 4, der ein Freilaufelement F aufweist, das den Freilaufstrom nur in einer Richtung passieren läßt. Insbesondere ist das Freilaufelement F als Freilaufdiode ausgebildet. Ferner liegt im Freilaufkreis 4 ein Shunt $S_H$, der als ohmscher Widerstand $R_S$ ausgebildet ist. Die Reihenschaltung aus Freilaufelement F und Shunt $S_H$ liegt parallel zur Reihenschaltung vom Widerstand $R_A$ und Spule $L_A$ der Last 2. Im Freilaufkreis 4 fließt bei leitendem Freilaufelement F der Freilaufstrom $I_F$, der zu einem Spannungsabfall an dem Shunt $S_H$ führt, nämlich zur Shunt-Spannung $U_{RS}$.
Grundsätzlich sei erwähnt, daß alle Strom- und Spannungsangaben Mittelwerte darstellen. So bildet die Motorspannung $U_M$ den Mittelwert der an der Last 2 anliegenden Spannung, der Versorgungsstrom $I_B$ den Mittelwert des von der Versorgung entnommenen Stroms, der Motorstrom $I_M$ den Mittelwert des Motorstroms und der Freilaufstrom $I_F$ den Mittelwert des Freilaufstroms. Es gelten folgende Voraussetzungen: Der Widerstand $R_S$ des Shunts $S_H$ ist derart gewählt, daß er gegenüber dem ohmschen Widerstand $R_A$ der Last 2 vernachlässigbar klein ist. Auch ist der Spannungsabfall über dem Freilaufelement F, also über der Freilaufdiode, zu vernachlässigen. Ferner arbeitet die Endstufe im kontinuierlichen Betrieb, das heißt, für ein Tastverhältnis größer Null ist der Laststrom, also der Motorstrom $I_M$, zu jedem Zeitpunkt ebenfalls größer Null. Als Tastverhältnis können Werte zwischen 0 - 1 angenommen werden, wobei das Tastverhältnis D vom Quotienten der Motorspannung $U_M$ und der Versorgungsspannung $U_B$ gebildet ist oder vom Quotienten des Versorgungsstrom $I_B$ zum Motorstrom $I_M$.
Da während der Freilaufphase, also wenn sich der Schalter S in Offenstellung befindet, der Motorstrom $I_M$ weiterfließt, gilt für den Freilaufstrom

$$I_F = I_M \cdot (1-D).$$

Somit kann in Kenntnis des Tastverhältnisses D aus dem Freilaufstrom $I_F$ der Laststrom (Motorstrom $I_M$) nach folgender Beziehung ermittelt werden

$$I_M = \frac{I_F}{1-D}$$

Für die Schaltung der Figur 1 (für die der Index "1" verwendet wird) gilt für die Verlustleistung im Shunt

$$\begin{aligned}
P_{RS1} &= I_F^2 \cdot R_{S1} \\
&= \left( I_M \cdot (1-D) \right)^2 \cdot R_{S1} \\
&= \left( \frac{U_B \cdot D}{R_A} \cdot (1-D) \right)^2 \cdot R_{S1} \\
&= \frac{U_B^2 \cdot R_{S1}}{R_A^2} \cdot \left( D - D^2 \right)^2
\end{aligned}$$

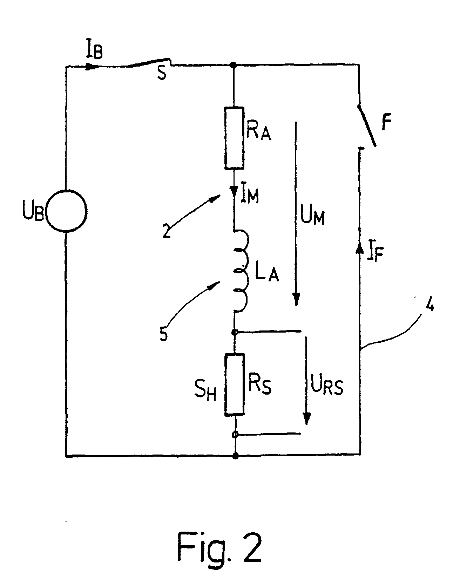

Die Figur 2 zeigt eine weitere erfindungsgemäße Schaltung. Hier liegt wiederum eine Versorgungsspannung $U_B$, die einen Versorgungsstrom $I_B$ liefert, über einen Schalter S, der wiederum als Endstufentransistor ausgebildet sein kann, an einer Reihenschaltung 5, die von dem ohmschen Anteil (Widerstand $R_A$), dem induktiven Anteil (Spule $L_A$) der Last 2 und dem Shunt $S_H$, also dem Widerstand $R_S$, gebildet ist. An der Last 2 fällt die Motorspannung $U_M$ und an dem Shunt $S_H$ die Spannung $U_{RS}$ ab. Parallel zur Reihenschaltung 5 liegt der Freilaufkreis 4, der ein Freilaufelement F aufweist. Das Freilaufelement F ist also parallel zu der Reihenschaltung 5 geschaltet, die von dem Widerstand $R_A$, der Spule $L_A$ und dem Widerstand $R_S$ gebildet ist. Im Freilaufkreis fließt bei geschlossenem Freilaufelement F und geöffnetem Schalter S der Freilaufstrom $I_F$.
Die Verlustleistung des Shunts der Schaltung der Figur 2 ergibt nach folgender Beziehung

$$P_{RS2} = I_M^2 \cdot R_{S2}$$

$$=\left(\frac{U_M}{R_A}\right)^2 \cdot R_{S2}$$

$$=\left(\frac{U_B \cdot D}{R_A}\right)^2 \cdot R_{S2}$$

$$=\frac{U_B^2 \cdot R_{S2}}{R_A^2} \cdot D^2$$

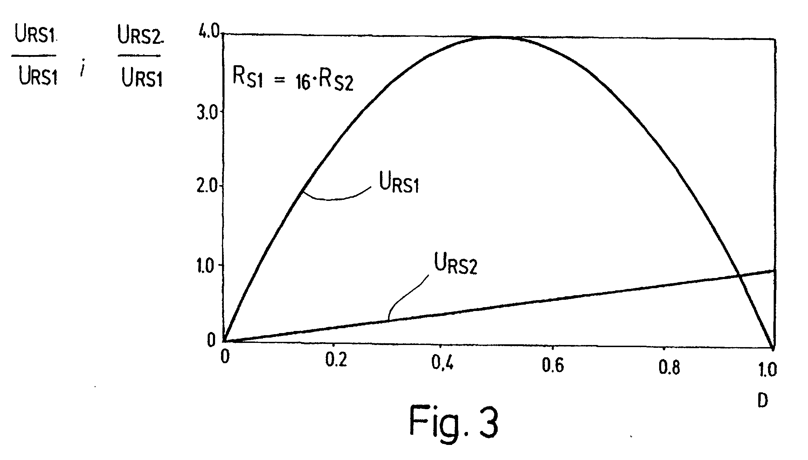

In den Figuren 3 bis 5 sind Diagramme dargestellt, die bestimmte Parameter der Schaltungen der Figuren 1 und 2 zeigen, wobei der Index "1" für die Schaltung der Figur 1 und der Index "2" für die Schaltung der Figur 2 gilt.

Auf der Abszisse der Figur 3 ist das Tastverhältnis D abgetragen. Auf der Ordinate ist die Spannung am Shunt nach der Schaltung der Figur 1 beziehungsweise der Figur 2 wiedergegeben, normiert auf den Maximalwert $U_{RS}1$. Es ist zu beachten, daß für dieselbe maximale Verlustleistung der Widerstand $R_{S1}$ des Shunts der Schaltung der Figur 1 um den Faktor 16 größer wählbar ist als der Widerstand $R_{S2}$ des Shunts der Schaltung der Figur 2, was einen viermal so großen Signalhub zur Folge hat.

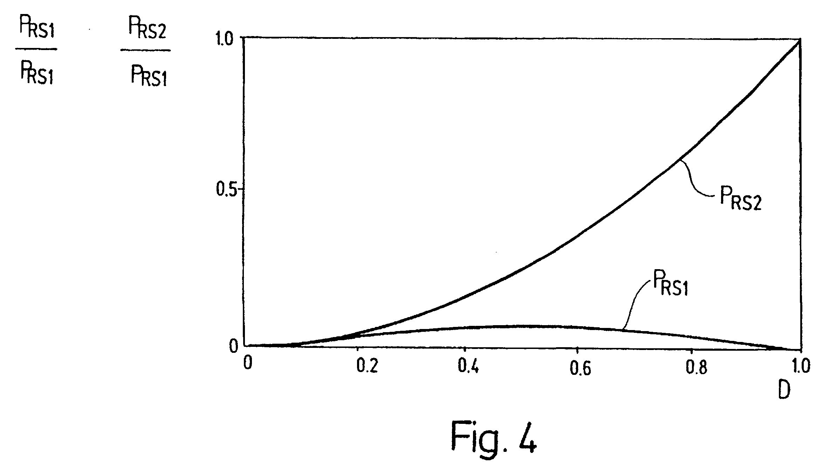

Die Figur 4 zeigt den Verlauf der Verlustleistungen in den Widerständen $R_{S1}$ und $R_{S2}$ des Shunts $S_H$ nach den Schaltungen der Figuren 1 und 2. Auf der Abszisse ist das Tastverhältnis D und auf der Ordinate die Verlustleistung $P_{RS1}$ beziehungsweise $P_{RS2}$ jeweils normiert auf den Maximalwert $P_{RS1}$ dargestellt. Es wird deutlich, daß die maximale Verlustleistung beim Gegenstand der Figur 1 um den Faktor 16 geringer ist als beim Gegenstand der Figur 2.

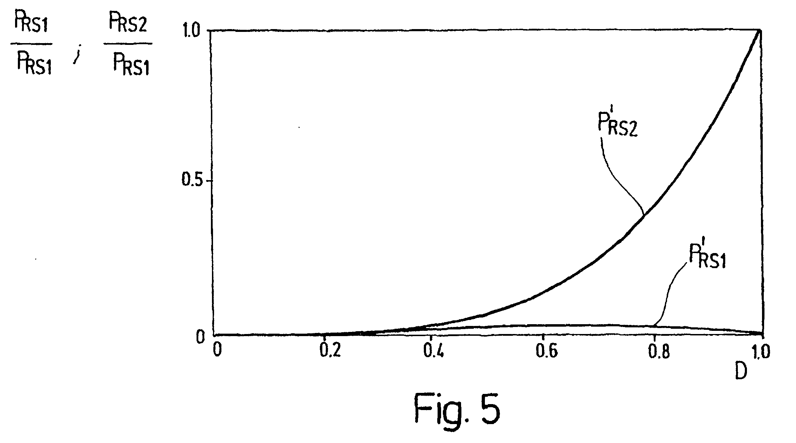

Die Figur 5 zeigt schließlich ein Diagramm, bei dem auf der Abszisse wiederum das Tastverhältnis D und auf der Ordinate die Verlustleistungen entsprechend der Figur 4 dargestellt sind. Das Diagramm der Figur 5 gilt für Lasten mit progressiver Kennlinie $I_M = f(U_M)$. Liegt beispielsweise eine quadratische Lastkennlinie $I_M = k \cdot U_M^2$ vor, so wie sie beispielsweise etwa einer Lüfterkennlinie entspricht, so ergeben sich die ersichtlichen Kennlinienverläufe. Es wird deutlich, daß die Verlustleistung im Shunt $S_H$ bei der Freilaufmessung gemäß Figur 1 um den Faktor 45 geringer ist als bei der Schaltung nach Figur 2.

**Patentansprüche**

1. Elektrische Schaltung zur Ermittlung des Laststroms $I_M$ einer getaktet angesteuerten, zumindest einen induktiven Anteil aufweisenden Last (2), der ein Freilaufkreis (4) zugeordnet ist, der einen Shunt ($S_H$) zur Ermittlung des Freilaufstroms $I_F$ enthält, **dadurch gekennzeichnet**, das der Laststrom $I_M$ aus der Beziehung

$$I_M = \frac{I_F}{1-D}$$

bestimmt wird, wobei D das Tastverhältnis der getakteten Ansteuerung ist.

2. Elektrische Schaltung zur Ermittlung des Laststroms $I_M$ einer getaktet angesteuerten, zumindest einen induktiven Anteil aufweisenden Last (2), der ein Freilaufkreis (4) zugeordnet ist, wobei die Schaltung einen Shunt ($S_H$) aufweist, der in Reihe zur Last (2) liegt und wobei der Freilaufkreis (4) parallel zu der Reihenschaltung von Last (2) und Shunt ($S_H$) angeordnet ist, **dadurch gekennzeichnet, daß** der Laststrrom $I_M$ aus der Beziehung

$$I_M = \frac{I_F}{1-D}$$

bestimmt wird, wobei D das Tastverhältnis der getakteten Ansteuerung ist.

3. Elektrische Schaltung nach einem der vorhergehenden Ansprüche, **dadurch gekennzeichnet, daß** die Last (2) ein Elektromotor, insbesondere ein permanent erregter Gleichstrommotor ist.

4. Elektrische Schaltung nach einem der vorhergehenden Ansprüche, **dadurch gekennzeichnet, daß** der Widerstand ($R_S$) des Shunts ($S_H$) sehr viel kleiner als der ohmsche Anteil des (Widerstandes ($R_A$) der Last (2) gewählt ist

5. Elektrische Schaltung nach einem der vorhergehenden Ansprüche, **dadurch gekennzeichnet, daß** das Tastverhältnis D definiert ist durch den Quotienten der Lastspannung, insbesondere Motorspannung ($U_M$), und der Versorgungspannung ($U_B$).

6. Elektrische Schaltung nach einem der vorhergehenden Ansprüche, **gekennzeichnet durch** eine Dimensionierung derart, daß während der Freilaufzeit der Laststrom, insbesondere Motorstrom $I_M$, in gleicher oder fast gleicher Höhe weiterfließt.

7. Elektrische Schaltung nach Anspruch 1, **dadurch gekennzeichnet, daß** der Motorstrom $I_M$ aus der Beziehung

$$\frac{U_{RS1} / R_{S1}}{1-D}$$

bestimmt wird, wobei $U_{RS1}$ die elektrische Spannung am Shunt ($S_H$), $R_{S1}$ der Widerstandwert des Shunts ($S_H$) und D das Tastverhältnis ist.

## Claims

1. Electrical circuit for determination of the load current $I_M$ of a clock-controlled load (2) which has at least one inductive component and with which a freewheeling circuit (4) is associated, which contains a shunt ($S_H$) for determination of the freewheeling current ($I_F$), **characterized in that** the load, $I_M$ is determined from the relationship

$$I_M = \frac{I_F}{1 - D}$$

where D is the duty ratio of the pulsed drive.

2. Electrical circuit for determination of the load current $I_M$ of a clock-controlled load (2) which has at least one inductive component and with which a freewheeling circuit (4) is associated, with the electrical circuit having a shunt ($S_H$) which is connected in series with the load (2), and with the freewheeling circuit (4) being arranged in parallel with the series circuit formed by the load (2) and the shunt ($S_H$), **characterized in that** the load $I_M$ is determined from the relationship

$$I_M = \frac{I_F}{1 - D}$$

where D is the duty ratio of the pulsed drive.

3. Electrical circuit according to one of the preceding claims, **characterized in that** the load (2) is an electric motor, in particular a DC motor with permanent-magnetic excitation.

4. Electrical circuit according to one of the preceding claims, **characterized in that** the resistance ($R_S$) of the shunt ($S_H$) is chosen to be very much less than the resistive component of the impedance ($R_A$) of the load (2).

5. Electrical circuit according to one of the preceding claims, **characterized in that** the duty ratio D is defined by the quotient of the load voltage, in particular the motor voltage ($U_M$), and the supply voltage ($U_B$).

6. Electrical circuit according to one of the preceding claims, **characterized by** said circuit being designed such that the load current, in particular the motor current $I_M$, continues to flow at the same magnitude, or virtually the same magnitude, during the freewheeling time.

7. Electrical circuit according to Claim 1, **characterized in that** the motor current $I_M$ is determined from the relationship

$$\frac{U_{RS1} / R_{S1}}{1 - D}$$

where $U_{RS1}$ is the electrical voltage across the shunt ($S_H$), $R_{S1}$ is the resistance of the shunt ($S_H$), and D is the duty ratio.

## Revendications

1. Circuit électrique pour déterminer le courant de charge $I_M$ d'une charge (2) commandée de manière cadencée ayant au moins une partie inductive à laquelle est associé un circuit de roue libre (4) comportant un shunt ($S_H$) pour déterminer le courant de roue libre $I_F$,
   **caractérisé en ce que**
   le courant de charge se détermine suivant la relation :

$$I_M = \frac{I_F}{1 - D}$$

dans laquelle D est le rapport de travail de la commande cadencée.

2. Circuit électrique pour déterminer le courant de charge $I_M$ d'une charge (2) à commande cadencée ayant au moins une composante inductive, et à laquelle est associé un circuit de roue libre (4), le circuit ayant un shunt ($S_H$) en série avec la charge et le circuit de roue libre (4) étant en parallèle au circuit série formé par la charge (2) et le shunt ($S_H$),
   **caractérisé en ce que**
   le courant de charge $I_M$ se détermine à partir de la relation :

$$I_M = \frac{I_F}{1 - D}$$

D étant le rapport de travail de la commandé cadencée.

3. Circuit électrique selon l'une des revendications précédentes,
   **caractérisé en ce que**
   la charge (2) est un moteur électrique notamment un moteur à courant continu à excitation permanente.

4. Circuit électrique selon l'une des revendications précédentes,
**caractérisé en ce que**
la résistance ($R_S$) du shunt ($S_H$) est choisie beaucoup plus petite que la composante ohmique de la résistance ($R_A$) de la charge (2).

5. Circuit électrique selon l'une des revendications précédentes,
   **caractérisé en ce que**
   le rapport de travail D est défini par le quotient de la tension de charge notamment de la tension du moteur ($U_M$) et de la tension d'alimentation ($U_B$).

6. Circuit électrique selon l'une des revendications précédentes,
   **caractérisé par**
   un dimensionnement tel que le courant de charge, notamment le courant du moteur ($I_M$) continue de passer avec la même amplitude ou pratiquement la même amplitude pendant le temps de roue libre.

7. Circuit électrique selon la revendication 1,
   **caractérisé en ce que**
   le courant ($I_M$) est défini par la relation :

$$\frac{U_{RS1}/R_{S1}}{1-D}$$

dans laquelle :

$U_{RS1}$ est la tension électrique sur le shunt ($S_H$),
$R_{S1}$ est la résistance du shunt ($S_H$), et
D est le rapport de travail.

Fig. 1

Fig. 2

$$\frac{U_{RS1}}{U_{RS1}} \; i \; \frac{U_{RS2}}{U_{RS1}}$$

$R_{S1} = 16 \cdot R_{S2}$

$U_{RS1}$

$U_{RS2}$

Fig. 3

EP 0 929 818 B1

Fig. 4

Fig. 5